# FASCICULE DE BREVET EUROPEEN

(11) **EP 3 469 634 B1**
(45) Date de publication et mention de la délivrance du brevet: **01.04.2020**
(21) Numéro de dépôt: 17784338.0
(22) Date de dépôt: 09.06.2017
(51) Int. Cl.: H01L 31/048, H01L 31/049, H01L 31/18

(54) **PROCEDE DE FABRICATION D'UN MODULE PHOTOVOLTAÏQUE**
VERFAHREN ZUR HERSTELLUNG EINES FOTOVOLTAIKMODULS
METHOD FOR MANUFACTURING A PHOTOVOLTAIC MODULE

(30) Priorité: 10.06.2016 FR 1655398
(43) Date de publication de la demande: 17.04.2019
(73) Titulaire: Commissariat à l'Énergie Atomique et aux Énergies Alternatives, 75015 Paris (FR); Concept Composites Auvergne- 2CA, 63220 Arlanc (FR)
(72) Inventeur: GAUME, Julien, 38110 La Tour du Pin (FR); DUISSARD, Gilles, 63490 Saint Jean en Val (FR); JAUBERT, Fabien, 73000 Chambéry (FR); ROUBY, France, 63600 Ambert (FR); RUOLS, Pierre, 73000 Chambéry (FR)
(74) Mandataire: Talbot, Alexandre
(86) Numéro de dépôt international: PCT/FR2017/051474
(87) Numéro de publication internationale: WO 2017/212194

(56) Documents cités:
- EP-A1- 2 660 876
- WO-A1-2016/077402
- US-A1- 2014 290 744

## Description

### Domaine technique

L'invention se rapporte au domaine technique des modules photovoltaïques légers, rigides et résistants. L'invention trouve notamment son application pour des systèmes autonomes et/ou embarqués.

### Définitions

Par « léger », on entend que le module photovoltaïque présente une masse surfacique inférieure ou égale à 7 kg/m², préférentiellement inférieure ou égale à 5 kg/m².

Par « rigide », on entend que le module photovoltaïque présente un rayon de courbure supérieur ou égal à 6 m en appliquant une pression de 2400 Pa uniformément répartie sur le module photovoltaïque.

Par « résistant », on entend que le module photovoltaïque présente des propriétés de résistance mécanique respectant les normes IEC 61215 et IEC 61730 de manière à être viable, fiable électriquement et structurellement.

### Etat de la technique antérieure

Un module photovoltaïque léger, rigide et résistant, connu du document US 2014/290744 A1, comporte un empilement comprenant successivement :
- une première couche, transparente dans le domaine visible ;
- un ensemble de cellules photovoltaïques encapsulées dans un matériau d'encapsulation ;
- une structure de support, agencée pour supporter l'ensemble de cellules photovoltaïques, et comprenant une couche de mousse ;
- une deuxième couche, agencée de part et d'autre de la structure de support.
La première couche n'est pas réalisée en verre afin d'alléger le module photovoltaïque. La structure de support, comprenant la couche de mousse, permet de répondre aux besoins des normes IEC 61215 et IEC 61730 quant à la résistance mécanique du module photovoltaïque. La deuxième couche permet de lier la structure de support à l'ensemble de cellules photovoltaïques encapsulées.

Un inconvénient d'un tel module photovoltaïque réside dans son procédé de fabrication nécessitant de fabriquer préalablement la structure de support et la deuxième couche, par exemple par laminage (cf. §0061). Puis, dans un second temps, la structure de support et la deuxième couche sont assemblées au reste du module photovoltaïque par des techniques conventionnelles (cf. §0062).

### Exposé de l'invention

L'invention vise à remédier en tout ou partie à l'inconvénient précité. A cet effet, l'invention a pour objet un procédé de fabrication d'un module photovoltaïque, comportant les étapes :
a) prévoir un empilement comprenant successivement :
   - une première couche, transparente dans le domaine visible, et réalisée dans un premier matériau pré-imprégné possédant une première température de cuisson,
   - un ensemble de cellules photovoltaïques encapsulées dans un matériau d'encapsulation,
   - une deuxième couche, réalisée dans un deuxième matériau pré-imprégné possédant une deuxième température de cuisson,
   - une structure de support, agencée pour supporter l'ensemble de cellules photovoltaïques,
   - une troisième couche, réalisée dans un troisième matériau pré-imprégné possédant une troisième température de cuisson,
   les premier, deuxième et troisième matériaux pré-imprégnés étant sélectionnés de sorte que, pour un temps de cuisson, les première, deuxième et troisième températures de cuisson sont inférieures à une température de laminage ;
b) laminer l'empilement à la température de laminage pendant une durée de laminage supérieure ou égale au temps de cuisson ;
la structure de support et les deuxième et troisième couches n'ayant pas été laminées avant l'étape b).

Ainsi, un tel procédé selon l'invention permet de fabriquer le module photovoltaïque en une seule étape b) de laminage (le terme lamination est également employé). Le temps d'opération et les coûts associés sont ainsi réduits.

Ceci est rendu possible grâce aux premier, deuxième et troisième matériaux pré-imprégnés et à leur sélection de sorte que, pour un temps de cuisson, les première, deuxième et troisième températures de cuisson sont inférieures à une température de laminage. Les premier, deuxième et troisième matériaux pré-imprégnés peuvent être ainsi formés par moulage lors de l'unique étape b) de laminage, et permettent de s'affranchir de couches adhésives pour lier les éléments du module photovoltaïque. Un tel procédé selon l'invention permet donc de s'affranchir d'étapes de collage post-moulage.

L'invention a également pour objet un module photovoltaïque comprenant un empilement, tel que défini dans la revendication indépendante 11.

### Définitions

- Par « matériau pré-imprégné », on entend un matériau composite comportant une matrice (ou résine) imprégnant un renfort. La matrice est une résine thermodurcissable ou une résine thermoplastique.
- Par « température de cuisson », on entend :
   la température à laquelle la résine du matériau pré-imprégné est réticulée, pour un temps de cuisson donné, lorsque la résine est thermodurcissable, ou
   la température à laquelle la résine du matériau pré-imprégné se ramollit et peut être mise en forme, pour un temps de cuisson donné, lorsque la résine est thermoplastique.

Les températures de cuisson et les temps de cuisson sont généralement donnés par le fabricant de la résine le cas échéant.

Le temps de cuisson, pour lequel sont sélectionnés lors de l'étape a) les premier, deuxième et troisième matériaux pré-imprégnés, est supérieur ou égal au maximum des temps de cuisson donnés respectifs des premier, deuxième et troisième matériaux pré-imprégnés.

Lorsque le matériau pré-imprégné comporte une résine thermoplastique possédant une température de transition vitreuse, la résine thermoplastique est choisie de sorte que la température de transition vitreuse est inférieure à la température de laminage. Il est alors possible de mettre en forme la résine thermoplastique sans rupture durant l'étape b) de laminage. La résine thermoplastique se solidifie après l'étape b) de laminage, en refroidissant.
- Par « couche », on entend une ou plusieurs couches de même nature.
- Par « transparent », on entend que le coefficient de transmission moyenné dans le domaine visible est supérieur ou égal à 75%, préférentiellement supérieur ou égal à 80%, plus préférentiellement supérieur ou égal à 85%.
- Par « encapsulées », on entend que les cellules photovoltaïques sont isolées électriquement, et protégées du milieu extérieur (notamment de l'humidité) en étant enrobées au sein du matériau d'encapsulation, par exemple entre deux couches du matériau encapsulant.
- Par « laminer », on entend l'opération consistant à assembler les différents éléments de l'empilement en appliquant une pression afin de le mettre en forme. Cette opération est exécutée à l'aide d'un laminoir (le terme laminateur est également employé), le laminoir pouvant être, par exemple, une presse à membrane ou une presse à plateaux chauffants.
- Par « successivement », on entend que les différents éléments de l'empilement viennent à la suite selon l'ordre indiqué, mais pas nécessairement en contact. En d'autres termes, le terme « successivement » n'exclut pas la présence d'élément(s) intercalaire(s) au sein de l'empilement.

Le procédé selon l'invention peut comporter une ou plusieurs des caractéristiques suivantes.

Selon une caractéristique de l'invention, l'étape a) comporte une étape a₁) consistant à agencer les première, deuxième et troisième couches autour de l'empilement de manière à former un cadre pour le module photovoltaïque.
Ainsi, un avantage procuré est de former le cadre du module photovoltaïque simultanément avec le module photovoltaïque, lors de l'unique étape b) de laminage. Dans l'état de la technique, le cadre du module photovoltaïque est classiquement réalisé sous la forme d'un profilé en aluminium, et est assemblé par collage après la fabrication du module photovoltaïque. En outre, un cadre réalisé dans les premier, deuxième et troisième matériaux pré-imprégnés permet un allégement significatif relativement à un cadre en aluminium.

Selon une caractéristique de l'invention, l'étape a) comporte une étape a₂) consistant à agencer des cales autour de l'empilement de manière à délimiter le cadre et immobiliser l'empilement.
Ainsi, un avantage procuré par les cales est de faciliter l'encadrement du module photovoltaïque afin d'obtenir une bordure de bonne qualité, sans délaminage (le terme délamination est également employé) préjudiciable. Les cales permettent d'homogénéiser la pression de laminage appliquée à l'empilement lors de l'étape b).

Selon une caractéristique de l'invention, les cales agencées lors l'étape a₂) comportent chacune :
- une première partie, de préférence métallique ;
- une seconde partie, s'étendant entre la première partie et l'empilement, et réalisée dans un matériau possédant un coefficient de dilatation thermique compris entre 200 x 10⁻⁶ K⁻¹ et 400 x 10⁻⁶ K⁻¹ à la température de laminage.
Ainsi, un avantage procuré par la première partie des cales est de délimiter le cadre du module photovoltaïque et maintenir la seconde partie des cales. En outre, un avantage procuré par la seconde partie des cales est l'obtention d'un excellent maintien de l'empilement lors de l'étape b) de laminage, sans risque de rupture mécanique.
A la température de laminage, le coefficient de dilatation thermique du matériau de la seconde partie doit être :
- supérieur à un premier seuil en deçà duquel la dilatation du matériau est trop faible relativement à la dilatation de l'empilement de sorte qu'il existe un risque de rupture mécanique de l'empilement;
- inférieur à un second seuil au-delà duquel la dilatation du matériau est trop importante relativement à la dilatation de l'empilement de sorte que l'empilement n'est plus maintenu de manière satisfaisante.
Autrement dit, le coefficient de dilatation thermique du matériau de la seconde partie des cales est adapté au coefficient de dilatation thermique de l'empilement de manière à compacter la périphérie de l'empilement et donner à l'empilement sa résistance mécanique.

Selon une caractéristique de l'invention, l'étape a) comporte une étape a₃) consistant à disposer au moins une boîte de jonction au sein de la structure de support, l'étape a₃) étant exécutée avant l'étape b).
Ainsi, un avantage procuré est d'intégrer la ou les boîtes de jonction au module photovoltaïque avant sa fabrication. Il est ainsi possible de s'affranchir d'une surépaisseur intervenant lorsque la ou les boîtes de jonction sont collées au module photovoltaïque après sa fabrication.

Selon une caractéristique de l'invention, les premier, deuxième et troisième matériaux pré-imprégnés comportent chacun :
- une matrice d'un polymère thermodurcissable ou d'un polymère thermoplastique ; le polymère thermodurcissable étant de préférence sélectionné dans le groupe comportant un polyester, un polyépoxyde ; le polymère thermoplastique étant de préférence l'acrylique ;
- des fibres d'un matériau de renfort, de préférence sélectionné dans le groupe comportant le verre, le carbone, un aramide.
Ainsi, un avantage procuré par ces matériaux est lié à leurs propriétés physiques et chimiques telles que la tenue mécanique, la résistance au rayonnement ultraviolet, la stabilité à l'hydrolyse etc.

Selon une caractéristique de l'invention, les fibres du premier matériau pré-imprégné sont des fibres de verre présentant :
- une masse surfacique comprise entre 100 g/m² et 500 g/m², et
- un taux massique compris entre 50% et 70%.
Ainsi, un avantage procuré est d'autoriser l'obtention d'un coefficient de transmission élevé dans le visible pour la première couche, typiquement supérieur à 80%.

Selon une caractéristique de l'invention, la première couche présente une épaisseur inférieure à 800 µm après l'étape b).

Ainsi, un avantage procuré est d'autoriser l'obtention d'un coefficient de transmission élevé dans le visible pour la première couche, typiquement supérieur à 80%.

Selon une caractéristique de l'invention, la structure de support comporte une couche alvéolaire.
Par « couche alvéolaire », on entend une couche comprenant un ensemble de cavités ménagées en son sein.
Ainsi, un avantage procuré est d'assurer la tenue mécanique de l'empilement sans augmenter sa masse de manière excessive.

Selon une caractéristique de l'invention, la couche alvéolaire est réalisée dans un matériau sélectionné dans le groupe comportant un aramide, l'aluminium, le propylène, le polycarbonate.

Selon une caractéristique de l'invention, la couche alvéolaire présente une épaisseur comprise entre 2 mm et 15 mm, de préférence comprise entre 8 mm et 12 mm, avant l'étape b).
Ainsi, un avantage procuré par ces dimensions est d'autoriser l'obtention d'un module photovoltaïque à la fois résistant et léger.

Selon une caractéristique de l'invention, la couche alvéolaire comporte des alvéoles présentant chacune une section transversale en forme d'un hexagone régulier, inscrit dans un cercle d'un diamètre compris entre 2 mm et 6 mm.
Ainsi, un avantage procuré par ces dimensions est d'autoriser l'obtention d'un module photovoltaïque résistant.
Par « transversale », on entend une direction perpendiculaire à la direction de l'empilement. La direction de l'empilement est la direction suivant laquelle les éléments sont empilés.

Selon une caractéristique de l'invention, la température de laminage est comprise entre 130°C et 170°C.

Ainsi, un avantage procuré est que cette gamme de température est facilement accessible pour un laminoir de type presse à membrane.

Selon une caractéristique de l'invention, l'étape b) est exécutée en mettant sous vide l'empilement, le vide étant de préférence inférieur à 10³ Pa.
Ainsi, un avantage procuré est de réaliser un moulage sous vide des premier, deuxième et troisième matériaux pré-imprégnés, ce qui permet d'améliorer leur qualité.

Selon une caractéristique de l'invention, la durée de laminage est d'au moins 15 minutes.

Selon une caractéristique de l'invention, l'étape b) est exécutée en appliquant à l'empilement une pression de laminage comprise entre 0,5 x 10⁵ Pa et 5 x 10⁵ Pa.

Selon une caractéristique de l'invention, le matériau d'encapsulation est à base d'un polymère thermodurcissable, de préférence à base d'éthylène-acétate de vinyle. Ainsi, l'éthylène-acétate de vinyle permet d'isoler électriquement les cellules photovoltaïques, et de les protéger du milieu extérieur. L'éthylène-acétate de vinyle possède un agent réticulant de manière à former un polymère thermodurcissable.

Selon une caractéristique de l'invention, le matériau d'encapsulation est à base d'un polymère thermoplastique, de préférence sélectionné dans le groupe comportant une polyoléfine, le silicone, le polyuréthane, le polybutyral de vinyle.
Ainsi, un avantage procuré par ces matériaux est d'isoler électriquement les cellules photovoltaïques, et de les protéger du milieu extérieur.

Selon une caractéristique de l'invention, l'empilement présente une épaisseur inférieure à 20 mm, de préférence inférieure à 15 mm, après l'étape b).
Ainsi, un avantage procuré est l'obtention d'un module photovoltaïque léger et compact.

L'invention a également pour objet un module photovoltaïque susceptible d'être obtenu par un procédé conforme à l'invention.

### Brève description des dessins

D'autres caractéristiques et avantages apparaîtront dans l'exposé détaillé de différents modes de réalisation de l'invention, l'exposé étant assorti d'exemples et de référence aux dessins joints.
Figure 1 est une vue schématique en coupe éclatée d'un module photovoltaïque fabriqué selon un premier mode de réalisation.
Figure 2 est une vue schématique en coupe éclatée d'un module photovoltaïque fabriqué selon un deuxième mode de réalisation.
Figure 3 est une vue schématique en perspective éclatée du module photovoltaïque illustré à la figure 2.
Figure 4 est une vue schématique en coupe éclatée d'un module photovoltaïque fabriqué selon un troisième mode de réalisation.
Figure 5 est une vue schématique de dessus d'un module photovoltaïque fabriqué selon un quatrième mode de réalisation.
Figure 6 est une vue schématique de côté du module photovoltaïque illustré à la figure 5.
Figure 7 est une vue schématique de dessus d'un module photovoltaïque fabriqué selon un cinquième mode de réalisation.
Figure 8 est une vue schématique de côté du module photovoltaïque illustré à la figure 7.
Bien entendu, contrairement à ce que laissent paraître les vues en éclaté, les éléments adjacents de l'empilement sont en réalité en contact.
Les éléments identiques ou assurant la même fonction porteront les mêmes références pour les différents modes de réalisation, par souci de simplification.

### Exposé détaillé des modes de réalisation

Un objet de l'invention est un procédé de fabrication d'un module photovoltaïque, comportant les étapes :
a) prévoir un empilement 1 comprenant successivement :
   - une première couche 10, transparente dans le domaine visible, et réalisée dans un premier matériau pré-imprégné possédant une première température de cuisson,
   - un ensemble de cellules 2 photovoltaïques encapsulées dans un matériau d'encapsulation 3,
   - une deuxième couche 11, réalisée dans un deuxième matériau pré-imprégné possédant une deuxième température de cuisson,
   - une structure de support 4, agencée pour supporter l'ensemble de cellules 2 photovoltaïques,
   - une troisième couche 12, réalisée dans un troisième matériau pré-imprégné possédant une troisième température de cuisson,
   les premier, deuxième et troisième matériaux pré-imprégnés étant sélectionnés de sorte que, pour un temps de cuisson, les première, deuxième et troisième températures de cuisson sont inférieures à une température de laminage ;
b) laminer l'empilement 1 à la température de laminage pendant une durée de laminage supérieure ou égale au temps de cuisson ; la structure de support 4 et les deuxième et troisième couches 11, 12 n'ayant pas été laminées avant l'étape b).

### Première couche

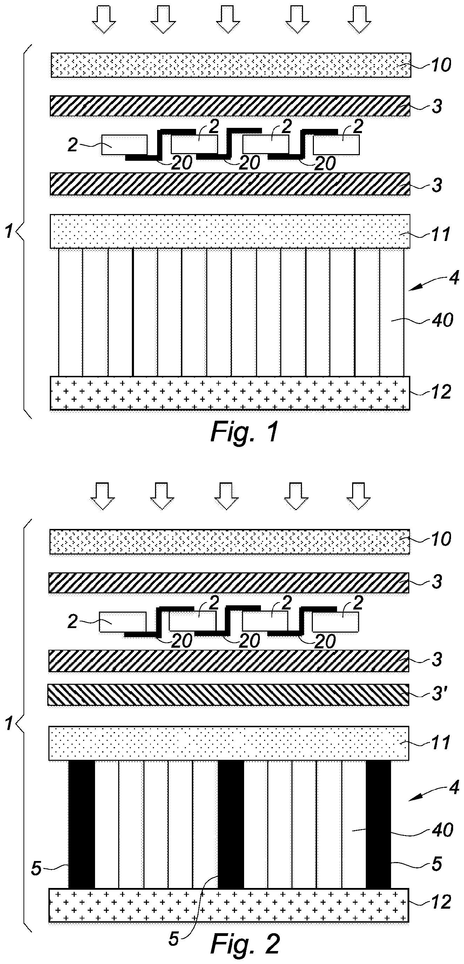

La première couche 10 est destinée à être exposée à un rayonnement lumineux, symbolisé par des flèches aux figures 1, 2 et 4.

Le premier matériau pré-imprégné peut comporter :
- une matrice d'un polymère thermodurcissable, de préférence sélectionné dans le groupe comportant un polyester, un polyépoxyde ;
- des fibres d'un matériau de renfort, de préférence sélectionné dans le groupe comportant le verre, le carbone, un aramide.

Le premier matériau pré-imprégné peut comporter :
- une matrice d'un polymère thermoplastique, de préférence l'acrylique ;
- des fibres d'un matériau de renfort, de préférence sélectionné dans le groupe comportant le verre, le carbone, un aramide.

Les fibres du premier matériau pré-imprégné sont avantageusement des fibres de verre présentant :
- une masse surfacique comprise entre 100 g/m² et 500 g/m², et
- un taux massique compris entre 50% et 70%.
La masse surfacique est préférentiellement comprise entre 200 g/m² et 400 g/m². Les fibres du premier matériau pré-imprégné sont préférentiellement tissées.

La première couche 10 présente préférentiellement une épaisseur inférieure à 800 µm après l'étape b). L'épaisseur de la première couche 10 dépend notamment de la masse surfacique et du taux massique des fibres de verre du premier matériau pré-imprégné.

### Cellules photovoltaïques

Les cellules 2 photovoltaïques sont avantageusement reliées électriquement entre elles par des connecteurs de liaison 20. L'ensemble des cellules 2 photovoltaïques est réparti au sein d'une pluralité de chaînes. Les cellules 2 photovoltaïques sont préférentiellement espacées entre elles d'une distance supérieure ou égale à 1 mm au sein d'une chaîne. Les cellules 2 photovoltaïques sont préférentiellement espacées d'une distance supérieure ou égale à 1 mm entre deux chaînes adjacentes. Chaque cellule 2 photovoltaïque présente préférentiellement une épaisseur inférieure ou égale à 250 µm. Les cellules 2 photovoltaïques peuvent être réalisées en silicium monocristallin ou polycristallin. Les cellules 2 photovoltaïques peuvent être à homojonction ou à hétérojonction.

### Encapsulation

Le matériau d'encapsulation 3 peut être à base d'un polymère thermodurcissable. Le polymère thermodurcissable est de préférence à base d'éthylène-acétate de vinyle. L'éthylène-acétate de vinyle possède un agent réticulant de manière à former un polymère thermodurcissable.

Le matériau d'encapsulation 3 peut être à base d'un polymère thermoplastique possédant une température de transition vitreuse. Le matériau d'encapsulation 3 est sélectionné lors de l'étape a) de sorte que la température de transition vitreuse est inférieure à la température de laminage. Il est alors possible de mettre en forme le matériau d'encapsulation 3 sans rupture durant l'étape b) de laminage. Le matériau d'encapsulation 3 se solidifie après l'étape b) de laminage, en refroidissant. Le polymère thermoplastique est de préférence sélectionné dans le groupe comportant une polyoléfine, le silicone, le polyuréthane, le polybutyral de vinyle.

Le matériau d'encapsulation 3 possède une température de cuisson, c'est-à-dire :
- la température à laquelle le polymère thermodurcissable est réticulé, pour un temps de cuisson donné, lorsque le matériau d'encapsulation 3 est à base d'un polymère thermodurcissable ; ou
- la température à laquelle le polymère thermoplastique se ramollit et peut être mis en forme, pour un temps de cuisson donné, lorsque le matériau d'encapsulation 3 est à base d'un polymère thermoplastique.
Les températures de cuisson et les temps de cuisson sont généralement donnés par le fabricant du polymère le cas échéant.
Le matériau d'encapsulation 3 est choisi lors de l'étape a) de sorte que sa température de cuisson est inférieure à la température de laminage. Le temps de cuisson, pour lequel sont sélectionnés lors de l'étape a) les premier, deuxième et troisième matériaux pré-imprégnés, est supérieur ou égal au maximum des temps de cuisson donnés respectifs des premier, deuxième, troisième matériaux pré-imprégnés et du matériau d'encapsulation 3. Ainsi, il est possible de fabriquer le module photovoltaïque en une seule étape b) de laminage. L'encapsulation de l'ensemble des cellules 2 photovoltaïques dans le matériau d'encapsulation 3 est effective à l'issue de l'étape b). En d'autres termes, l'ensemble de cellules 2 photovoltaïques n'est pas pré-encapsulé de manière effective lors de l'étape a). Autrement dit, le matériau d'encapsulation 3 n'a pas été mis en œuvre (mis en forme) avant l'étape b).

Plus précisément, comme illustré aux figures 1 à 4, l'empilement 1 prévu lors de l'étape a) peut comporter deux couches d'encapsulation réalisées dans le matériau d'encapsulation 3. Les deux couches d'encapsulation sont agencées lors de l'étape a) de part et d'autre de l'ensemble des cellules 2 photovoltaïques. A l'issue de l'étape b), les deux couches d'encapsulation ne forment plus qu'une seule couche d'encapsulation à l'intérieur de laquelle est noyé l'ensemble des cellules 2 photovoltaïques. A l'issue de l'étape b), la couche d'encapsulation à l'intérieur de laquelle est noyé l'ensemble des cellules 2 photovoltaïques présente préférentiellement une épaisseur comprise entre 100 µm et 1000 µm.

Comme illustré à la figure 2, l'empilement 1 prévu lors de l'étape a) peut comporter une couche d'encapsulation 3' additionnelle, réalisée dans un polymère blanc, et agencée entre une couche d'encapsulation et la deuxième couche 11.

### Structure de support

La structure de support 4 comporte avantageusement une couche alvéolaire 40. La couche alvéolaire 40 est préférentiellement réalisée dans un matériau sélectionné dans le groupe comportant un aramide, l'aluminium, le propylène, le polycarbonate. Le matériau de la couche alvéolaire 40 est avantageusement choisi de manière à ne pas être dégradé lors de l'étape b). En effet, la structure de support 4 apporte la rigidité au module photovoltaïque. La structure de support 4 est donc avantageusement identique avant et après l'étape b) en termes de géométrie et de propriétés.

Ainsi, lorsque le matériau de la couche alvéolaire est à base d'un polymère thermoplastique possédant une température de transition vitreuse, ledit matériau est sélectionné de sorte que la température de transition vitreuse est supérieure à la température de laminage.

Ainsi, lorsque le matériau de la couche alvéolaire est à base d'un polymère thermodurcissable possédant une température de transition vitreuse, ledit matériau est sélectionné de sorte que la température de transition vitreuse est supérieure à la température de laminage.

Ainsi, lorsque le matériau de la couche alvéolaire est à base d'un métal possédant une température de fusion, ledit matériau est sélectionné de sorte que la température de fusion est supérieure à la température de laminage afin de conserver les formes alvéolaires durant l'étape b) de laminage.

La couche alvéolaire 40 présente avantageusement une épaisseur comprise entre 2 mm et 15 mm, de préférence comprise entre 8 mm et 12 mm, avant l'étape b). L'épaisseur de la couche alvéolaire 40 est adaptée selon l'application visée. La couche alvéolaire 40 comporte des alvéoles présentant avantageusement chacune une section transversale en forme d'un hexagone régulier (structure de type nid d'abeilles), inscrit dans un cercle d'un diamètre compris entre 2 mm et 6 mm.

### Deuxième couche

Le deuxième matériau pré-imprégné peut comporter :
- une matrice d'un polymère thermodurcissable, de préférence sélectionné dans le groupe comportant un polyester, un polyépoxyde ;
- des fibres d'un matériau de renfort, de préférence sélectionné dans le groupe comportant le verre, le carbone, un aramide.

Le deuxième matériau pré-imprégné peut comporter :
- une matrice d'un polymère thermoplastique, de préférence l'acrylique ;
- des fibres d'un matériau de renfort, de préférence sélectionné dans le groupe comportant le verre, le carbone, un aramide.

Les fibres du deuxième matériau pré-imprégné sont avantageusement des fibres de verre présentant :
- une masse surfacique comprise entre 100 g/m² et 500 g/m², et
- un taux massique compris entre 50% et 70%.
La masse surfacique est préférentiellement comprise entre 200 g/m² et 400 g/m². Les fibres du deuxième matériau pré-imprégné sont préférentiellement tissées.

Le deuxième matériau pré-imprégné peut être identique au premier matériau pré-imprégné.

### Troisième couche

La troisième couche 12 et la deuxième couche 11 sont agencées de part et d'autre de la structure de support 4, en contact avec la structure de support 4. La troisième couche 12 et la deuxième couche 11 sont avantageusement agencées pour entourer la structure de support 4.

Le troisième matériau pré-imprégné peut comporter :
- une matrice d'un polymère thermodurcissable, de préférence sélectionné dans le groupe comportant un polyester, un polyépoxyde ;
- des fibres d'un matériau de renfort, de préférence sélectionné dans le groupe comportant le verre, le carbone, un aramide.

Le troisième matériau pré-imprégné peut comporter :
- une matrice d'un polymère thermoplastique, de préférence l'acrylique ;
- des fibres d'un matériau de renfort, de préférence sélectionné dans le groupe comportant le verre, le carbone, un aramide.

Les fibres du troisième matériau pré-imprégné sont avantageusement des fibres de verre présentant :
- une masse surfacique comprise entre 100 g/m² et 500 g/m², et
- un taux massique compris entre 50% et 70%.
La masse surfacique est préférentiellement comprise entre 200 g/m² et 400 g/m². Les fibres du troisième matériau pré-imprégné sont préférentiellement tissées.

Le troisième matériau pré-imprégné peut être identique au premier matériau pré-imprégné et/ou au deuxième matériau pré-imprégné. L'utilisation de matériaux pré-imprégnés identiques est conditionnée au choix de l'équipement permettant d'exécuter l'étape b) de laminage.

### Etape b) de laminage

L'étape b) est exécutée à l'aide d'un laminoir, le laminoir pouvant être, par exemple, une presse à membrane ou une presse à plateaux chauffants. La température de laminage peut être comprise entre 130°C et 170°C. La température de laminage est préférentiellement 150°C. L'étape b) est avantageusement exécutée en mettant sous vide l'empilement 1, le vide étant de préférence inférieur à 10³ Pa. L'étape b) est avantageusement exécutée en appliquant à l'empilement 1 une pression de laminage comprise entre 0,5 x 10⁵ Pa et 5 x 10⁵ Pa. L'empilement 1 peut être mis sous vide à l'aide d'une membrane étanche. L'étape b) est préférentiellement exécutée pendant une durée de laminage d'au moins 15 minutes. L'empilement 1 présente une épaisseur inférieure à 20 mm, de préférence inférieure à 15 mm, après l'étape b).

### Cadre du module photovoltaïque

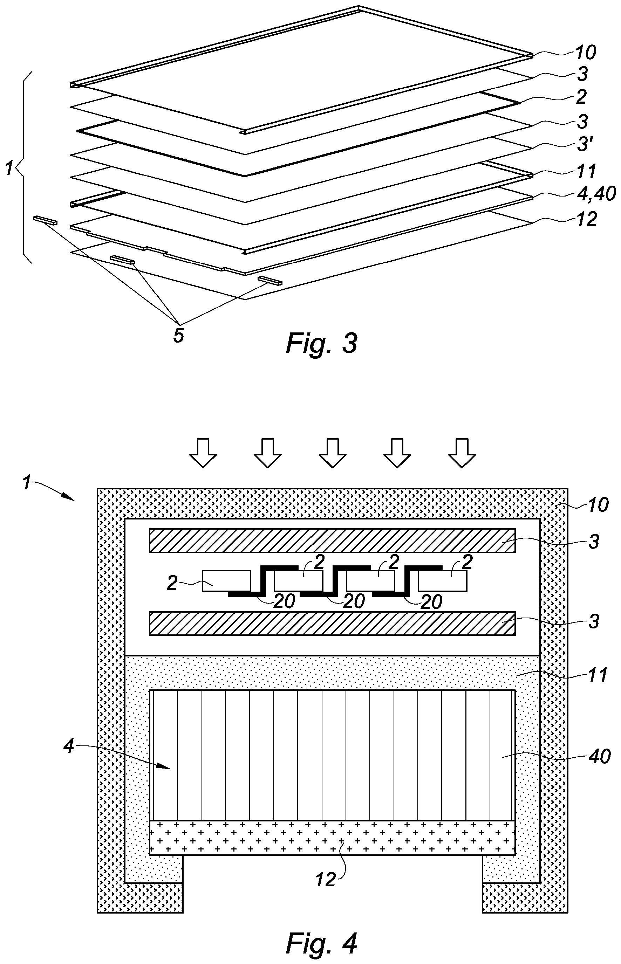

Comme illustré à la figure 4, l'étape a) comporte avantageusement une étape a₁) consistant à agencer les première, deuxième et troisième couches 10, 11, 12 autour de l'empilement 1 de manière à former un cadre pour le module photovoltaïque. Avantageusement, l'étape a₁) comporte une étape consistant à plier la deuxième couche 11 et à rabattre les plis sur la troisième couche 12. Puis, l'étape a₁) comporte avantageusement une étape consistant à plier la première couche 10 et à rabattre les plis sur la deuxième couche 11.

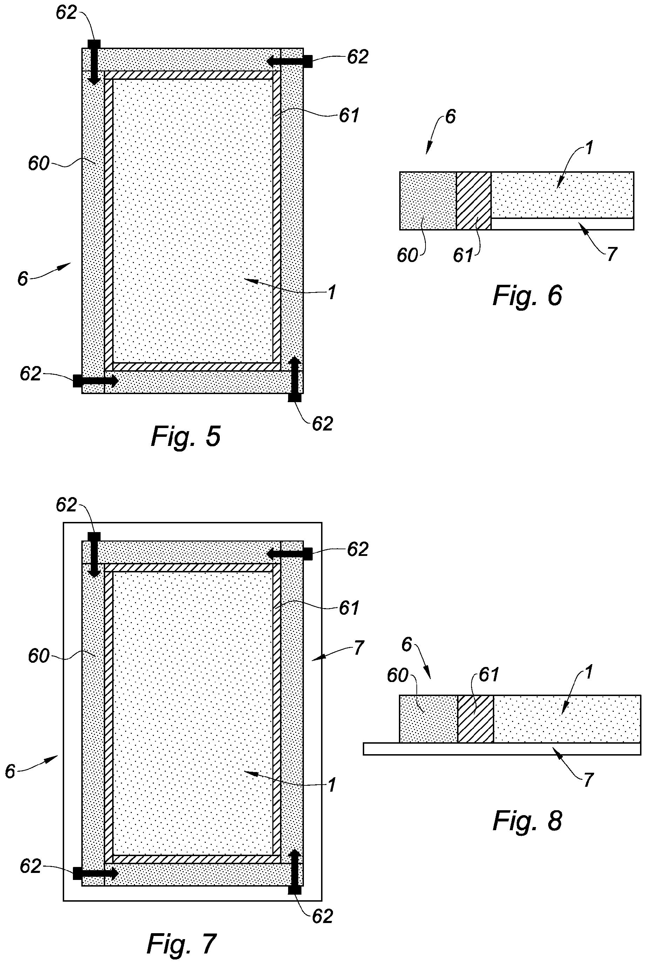

L'étape a) comporte avantageusement une étape a₂) consistant à agencer des cales 6 autour de l'empilement 1 de manière à délimiter le cadre et immobiliser l'empilement 1. Comme illustré aux figures 5 et 6, les cales 6 agencées lors l'étape a₂) comportent avantageusement chacune :
- une première partie 60, de préférence métallique ;
- une seconde partie 61, s'étendant entre la première partie 60 et l'empilement 1, et réalisée dans un matériau possédant un coefficient de dilatation thermique compris entre 200 x 10⁻⁶ K⁻¹ et 400 x 10⁻⁶ K⁻¹ à la température de laminage.
Les premières parties 60 des cales 6 sont fixées entre elles par des organes de fixation 62 tels que des vis de serrage.
La première partie 60 des cales 6 est de préférence réalisée dans un matériau possédant un coefficient de dilatation thermique inférieur à 10 x 10⁻⁶ K⁻¹.
Le matériau dans lequel est réalisée la seconde partie 61 des cales 6 est de préférence le silicone. Les cales 6 peuvent présenter une épaisseur de l'ordre de 16 mm. De manière générale, les cales 6 présentent une épaisseur adaptée à l'épaisseur finale du module photovoltaïque. Comme illustré à la figure 6, l'empilement 1 peut être agencé sur un moule 7. Les cales 6 peuvent être agencées autour du moule 7. Selon une alternative illustrée aux figures 7 et 8, les cales 6 peuvent être agencées sur le moule 7, dans sa périphérie. Le moule 7 peut être une plaque de verre enduite de téflon™. Le moule 7 peut être une plaque d'un matériau composite recouverte d'un film de téflon™. De manière générale, le moule 7 possède avantageusement un revêtement de surface adapté pour le démoulage du module photovoltaïque. Ainsi, le revêtement de surface peut être un film de téflon™. Le revêtement de surface peut être un démoulant semi-permanent, de type liquide ou encore de type cire en pâte.

### Boîtes de jonction

Comme illustré aux figures 2 et 3, l'étape a) comporte avantageusement une étape a₃) consistant à disposer au moins une boîte de jonction 5 (ou boîte de dérivation) au sein de la structure de support 4, l'étape a₃) étant exécutée avant l'étape b). Comme illustré à la figure 3, la ou les boîtes de jonction 5 peuvent être ménagées sur un bord de la couche alvéolaire 40 de la structure de support 4. La ou les boîtes de jonction 5 sont adaptées pour recevoir le câblage permettant le fonctionnement du module. Chaque boîte de jonction 5 comporte préférentiellement une diode de dérivation (bypass). Les boîtes de jonction 5 sont préférentiellement soudées à des rubans d'interconnexion.

### Exemple de réalisation

L'empilement 1 prévu lors de l'étape a) comprend successivement :
- la première couche 10, le premier matériau pré-imprégné comportant une matrice en polyépoxyde et des fibres de verre tissées présentant une masse surfacique de 300 g/m² ;
- l'ensemble de cellules 2 photovoltaïques encapsulées dans un matériau d'encapsulation à base d'éthylène-acétate de vinyle (EVA), et d'épaisseur 450 µm ; les cellules 2 photovoltaïques étant réalisées en silicium monocristallin, l'ensemble de cellules 2 photovoltaïques présentant des dimensions de 156 mm x 156 mm ;
- un encapsulant blanc 3' à base de EVA d'une épaisseur de 450 µm ;
- la deuxième couche 11, le deuxième matériau pré-imprégné comportant une matrice en polyépoxyde et des fibres de verre tissées présentant une masse surfacique de 300 g/m² ;
- la structure de support 4 comportant une couche alvéolaire 40, de type nid d'abeille, présentant une épaisseur de 12 mm, et réalisée en aramide de type Nomex ® ;
- la troisième couche 12, le troisième matériau pré-imprégné comportant une matrice en polyépoxyde et des fibres de verre tissées présentant une masse surfacique de 300 g/m².
L'étape b) consiste en une seule étape de laminage à chaud (de l'ordre de 150°C) sous vide de l'empilement 1, d'une durée d'au moins 15 minutes.
Le module photovoltaïque obtenu à l'issue de l'étape b) est fin (épaisseur inférieure à 15 mm), présente une masse surfacique inférieure à 4 kg/m² (de l'ordre de 3,7 kg/m²) et respecte les normes IEC 61215 et IEC 61730, en particulier pour la résistance mécanique. En outre, les performances électriques du module photovoltaïque sont tout-à-fait acceptables avec une puissance maximale de sortie de l'ordre de 240 W.

L'invention ne se limite pas aux modes de réalisation exposés. L'homme du métier est mis à même de considérer leurs combinaisons techniquement opérantes, et de leur substituer des équivalents.

## Revendications

1. Procédé de fabrication d'un module photovoltaïque, comportant les étapes :
a) prévoir un empilement (1) comprenant successivement :
- une première couche (10), transparente dans le domaine visible, et réalisée dans un premier matériau pré-imprégné possédant une première température de cuisson,
- un ensemble de cellules (2) photovoltaïques encapsulées dans un matériau d'encapsulation (3),
- une deuxième couche (11), réalisée dans un deuxième matériau pré-imprégné possédant une deuxième température de cuisson,
- une structure de support (4), agencée pour supporter l'ensemble de cellules (2) photovoltaïques,
- une troisième couche (12), réalisée dans un troisième matériau pré-imprégné possédant une troisième température de cuisson,
les premier, deuxième et troisième matériaux pré-imprégnés étant sélectionnés de sorte que, pour un temps de cuisson, les première, deuxième et troisième températures de cuisson sont inférieures à une température de laminage ;
b) laminer l'empilement (1) à la température de laminage pendant une durée de laminage supérieure ou égale au temps de cuisson ; la structure de support (4) et les deuxième et troisième couches (11, 12) n'ayant pas été laminées avant l'étape b).

2. Procédé selon la revendication 1, dans lequel l'étape a) comporte une étape a₁) consistant à agencer les première, deuxième et troisième couches (10, 11, 12) autour de l'empilement (1) de manière à former un cadre pour le module photovoltaïque et dans lequel l'étape a) comporte avantageusement une étape a₂) consistant à agencer des cales (6) autour de l'empilement (1) de manière à délimiter le cadre et immobiliser l'empilement (1).

3. Procédé selon la revendication 2, dans lequel les cales (6) agencées lors l'étape a₂) comportent chacune :
- une première partie (60), de préférence métallique ;
- une seconde partie (61), s'étendant entre la première partie et l'empilement, et réalisée dans un matériau possédant un coefficient de dilatation thermique compris entre 200 x 10⁻⁶ K⁻¹ et 400 x 10⁻⁶ K⁻¹ à la température de laminage.

4. Procédé selon l'une des revendications 1 à 3, dans lequel l'étape a) comporte une étape a₃) consistant à disposer au moins une boîte de jonction (5) au sein de la structure de support (4), l'étape a₃) étant exécutée avant l'étape b).

5. Procédé selon l'une des revendications 1 à 4, dans lequel les premier, deuxième et troisième matériaux pré-imprégnés comportent chacun :
- une matrice d'un polymère thermodurcissable ou d'un polymère thermoplastique ; le polymère thermodurcissable étant de préférence sélectionné dans le groupe comportant un polyester, un polyépoxyde ; le polymère thermoplastique étant de préférence l'acrylique ;
- des fibres d'un matériau de renfort, de préférence sélectionné dans le groupe comportant le verre, le carbone, un aramide
et dans lequel les fibres du premier matériau pré-imprégné sont préférentiellement des fibres de verre présentant :
- une masse surfacique comprise entre 100 g/m² et 500 g/m², et
- un taux massique compris entre 50% et 70%.

6. Procédé selon l'une des revendications 1 à 5, dans lequel la première couche (10) présente une épaisseur inférieure à 800 µm après l'étape b).

7. Procédé selon l'une des revendications 1 à 6, dans lequel la structure de support (4) comporte une couche alvéolaire (40) avantageusement réalisée dans un matériau sélectionné dans le groupe comportant un aramide, l'aluminium, le propylène, le polycarbonate et dans lequel la couche alvéolaire (40) présente avantageusement une épaisseur comprise entre 2 mm et 15 mm, de préférence comprise entre 8 mm et 12 mm, avant l'étape b).

8. Procédé selon l'une des revendications 1 à 7, dans lequel la température de laminage est comprise entre 130°C et 170°C et/ou la durée de laminage est d'au moins 15 minutes et/ou l'étape b) est exécutée en appliquant à l'empilement (1) une pression de laminage comprise entre 0,5 x 10⁵ Pa et 5 x 10⁵ Pa.

9. Procédé selon l'une des revendications 1 à 8, dans lequel le matériau d'encapsulation (3) est à base d'un polymère thermodurcissable, de préférence à base d'éthylène-acétate de vinyle ou à base d'un polymère thermoplastique, de préférence sélectionné dans le groupe comportant une polyoléfine, le silicone, le polyuréthane, le polybutyral de vinyle.

10. Procédé selon l'une des revendications 1 à 9, dans lequel l'empilement (1) présente une épaisseur inférieure à 20 mm, de préférence inférieure à 15 mm, après l'étape b).

11. Module photovoltaïque comprenant un empilement (1) comprenant successivement :
- une première couche (10), transparente dans le domaine visible, et réalisée dans un premier matériau pré-imprégné,
- un ensemble de cellules (2) photovoltaïques encapsulées dans un matériau d'encapsulation (3),
- une deuxième couche (11), réalisée dans un deuxième matériau pré-imprégné,
- une structure de support (4), agencée pour supporter l'ensemble de cellules (2) photovoltaïques,
- une troisième couche (12), réalisée dans un troisième matériau pré-imprégné, dans lequel les premier, deuxième et troisième matériaux pré-imprégnés comportent chacun :
- une matrice de polymère d'un matériau thermodurcissable avantageusement sélectionné dans le groupe comportant un polyester et un polyepoxyde, ou d'un polymère thermoplastique choisi parmi les polymères acryliques ;
- des fibres d'un matériau de renfort avantageusement sélectionné dans le groupe comportant le verre, le carbone et un aramide.

12. Module photovoltaïque selon la revendication 11, dans lequel les fibres du premier matériau pré-imprégné sont des fibres de verre présentant :
- une masse surfacique comprise entre 100 g/m² et 500 g/m², et
- un taux massique compris entre 50% et 70%.

13. Module photovoltaïque selon l'une des revendications 11 et 12, dans lequel la première couche (10) présente une épaisseur inférieure à 800 µm.

14. Module photovoltaïque selon l'une des revendications 11 à 13, dans lequel la structure de support (4) comporte une couche alvéolaire (40) et préférentiellement dans lequel la couche alvéolaire (40) est réalisée dans un matériau sélectionné dans le groupe comportant un aramide, l'aluminium, le propylène, le polycarbonate.

15. Module photovoltaïque selon l'une quelconque des revendications 11 à 14, dans lequel l'empilement (1) présente une épaisseur inférieure à 20 mm, de préférence inférieure à 15 mm.

## Patentansprüche

1. Verfahren zur Herstellung eines Fotovoltaik-Moduls, umfassend die folgenden Schritte:
a) Vorsehen eines Stapels (1), umfassend nacheinander:
- eine erste Schicht (10), die im sichtbaren Bereich transparent und aus einem ersten vorimprägnierten Material hergestellt ist, das eine erste Siedetemperatur besitzt,
- eine Gesamtheit von Fotovoltaik-Zellen (2), die in einem Verkapselungsmaterial (3) verkapselt sind,
- eine zweite Schicht (11), die aus einem zweiten vorimprägnierten Material hergestellt ist, das eine zweite Siedetemperatur besitzt,
- eine Tragstruktur (4), die dazu vorgesehen ist, die Gesamtheit von Fotovoltaik-Zellen (2) zu tragen,
- eine dritte Schicht (12), die aus einem dritten vorimprägnierten Material hergestellt ist, das eine dritte Siedetemperatur besitzt,
wobei das erste, zweite und dritte vorimprägnierte Material derart ausgewählt sind, dass für eine Siedezeit die erste, zweite und dritte Siedetemperatur niedriger als eine Walztemperatur sind;
b) Walzen des Stapels (1) bei der Walztemperatur während einer Walzdauer größer oder gleich der Siededauer; wobei die Tragstruktur (4) und die zweite und dritte Schicht (11, 12) vor dem Schritt b) nicht gewalzt wurden.

2. Verfahren nach Anspruch 1, bei dem der Schritt a) einen Schritt a₁) umfasst, der darin besteht, die erste, zweite und dritte Schicht (10, 11, 12) um den Stapel (1) herum anzuordnen, um einen Rahmen für das Fotovoltaik-Modul zu bilden, und bei dem der Schritt a) vorteilhafterweise einen Schritt a₂) umfasst, der darin besteht, Keile (6) um den Stapel (1) herum anzuordnen, um den Rahmen zu begrenzen und den Stapel (1) zu fixieren.

3. Verfahren nach Anspruch 2, bei dem die Keile (6), die in Schritt a₂) angeordnet werden, jeweils umfassen:
- einen ersten vorzugsweise metallischen Teil (60);
- einen zweiten Teil (61), der sich zwischen dem ersten Teil und dem Stapel erstreckt und aus einem Material hergestellt ist, das einen Wärmeausdehnungskoeffizienten zwischen 200x10⁻⁶K⁻¹ und 400x10⁻⁶K⁻¹ bei der Walztemperatur besitzt.

4. Verfahren nach einem der Ansprüche 1 bis 3, bei dem der Schritt a) einen Schritt a₃) umfasst, der darin besteht, mindestens eine Anschlussbox (5) innerhalb der Tragstruktur (4) anzuordnen, wobei der Schritt a₃) vor dem Schritt b) ausgeführt wird.

5. Verfahren nach einem der Ansprüche 1 bis 4, bei dem das erste, zweite und dritte vorimprägnierte Material jeweils umfassen:
- eine Matrix aus einem duroplastischen Polymer oder einem thermoplastischen Polymer; wobei das duroplastische Polymer vorzugsweise aus der Gruppe umfassend ein Polyester und ein Polyepoxid ausgewählt ist; wobei das thermoplastische Polymer vorzugsweise Acryl ist;
- Fasern aus einem Verstärkungsmaterial, das vorzugsweise aus der Gruppe umfassend Glas, Kohlenstoff, und ein Aramid ausgewählt ist,
und bei dem die Fasern des ersten vorimprägnierten Materials vorzugsweise Glasfasern sind, umfassend:
- eine Flächenmasse zwischen 100 g/m² und 500 g/m²; und
- einen Masseanteil zwischen 50 % und 70 %.

6. Verfahren nach einem der Ansprüche 1 bis 5, bei dem die erste Schicht (10) eine Dicke unter 800 µm nach dem Schritt b) aufweist.

7. Verfahren nach einem der Ansprüche 1 bis 6, bei dem die Tragstruktur (4) eine Schaumschicht (40) umfasst, die vorteilhafterweise aus einem ersten Material hergestellt ist, das aus der Gruppe umfassend ein Aramid, Aluminium, Propylen, und Polycarbonat ausgewählt ist, und bei dem die Schaumschicht (40) vorteilhafterweise eine Dicke zwischen 2 mm und 15 mm, vorzugsweise zwischen 8 mm und 12 mm, vor dem Schritt b) aufweist.

8. Verfahren nach einem der Ansprüche 1 bis 7, bei dem die Walztemperatur zwischen 130 °C und 170 °C beträgt, und/oder die Walzdauer mindestens 15 Minuten beträgt, und/oder der Schritt b) ausgeführt wird, wobei an den Stapel (1) ein Walzdruck zwischen 0,5 x 10⁵ Pa und 5 x 10⁵ Pa angelegt wird.

9. Verfahren nach einem der Ansprüche 1 bis 8, bei dem das Verkapselungsmaterial (3) auf Basis eines duroplastischen Polymers, vorzugsweise auf Basis von Ethylen-Vinylacetat, oder auf Basis eines thermoplastischen Polymers ist, vorzugsweise aus der Gruppe umfassend ein Polyolefin, Silikon, Polyurethan, und Vinylpolybutyral ausgewählt ist.

10. Verfahren nach einem der Ansprüche 1 bis 9, bei dem der Stapel (1) eine Dicke unter 20 mm, vorzugsweise unter 15 mm, nach dem Schritt b) aufweist.

11. Fotovoltaik-Modul, umfassend einen Stapel (1), umfassend nacheinander:
- eine erste Schicht (10), die im sichtbaren Bereich transparent und aus einem ersten vorimprägnierten Material hergestellt ist,
- eine Gesamtheit von Fotovoltaik-Zellen (2), die in einem Verkapselungsmaterial (3) verkapselt sind,
- eine zweite Schicht (11), die aus einem zweiten vorimprägnierten Material hergestellt ist,
- eine Tragstruktur (4), die dazu vorgesehen ist, die Gesamtheit von Fotovoltaik-Zellen (2) zu tragen,
- eine dritte Schicht (12), die aus einem dritten vorimprägnierten Material hergestellt ist,
wobei das erste, zweite und dritte vorimprägnierte Material jeweils umfassen:
- eine Polymermatrix aus einem duroplastischen Material, das vorzugsweise aus der Gruppe umfassend ein Polyester und ein Polyepoxid ausgewählt ist, oder aus einem thermoplastischen Material, das unter den Acrylpolymeren ausgewählt ist;
- Fasern aus einem Verstärkungsmaterial, das vorzugsweise aus der Gruppe umfassend Glas, Kohlenstoff und ein Aramid ausgewählt ist.

12. Fotovoltaik-Modul nach Anspruch 11, bei dem die Fasern des ersten vorimprägnierten Materials vorzugsweise Glasfasern sind, umfassend:
- eine Flächenmasse zwischen 100 g/m² und 500 g/m²; und
- einen Masseanteil zwischen 50 % und 70 %.

13. Fotovoltaik-Modul nach einem der Ansprüche 11 und 12, bei dem die erste Schicht (10) eine Dicke unter 800 µm aufweist.

14. Fotovoltaik-Modul nach einem der Ansprüche 11 bis 13, bei dem die Tragstruktur (4) eine Schaumschicht (40) umfasst, und bei dem die Schaumschicht (40) vorteilhafterweise aus einem Material hergestellt ist, das aus der Gruppe umfassend ein Aramid, Aluminium, Propylen und Polycarbonat ausgewählt ist.

15. Fotovoltaik-Modul nach einem der Ansprüche 11 bis 14, bei dem der Stapel (1) eine Dicke unter 20 mm, vorzugsweise unter 15 mm, aufweist.

## Claims

1. Method for fabricating a photovoltaic module, comprising the steps of:
a) providing a stack (1) successively comprising:
- a first layer (10) transparent in the visible range and made from a first pre-impregnated material having a first curing temperature,
- a set of photovoltaic cells (2) encapsulated in an encapsulation material (3),
- a second layer (11) made from a second pre-impregnated material having a second curing temperature,
- a support structure (4) arranged to support the set of photovoltaic cells (2),
- a third layer (12) made from a third pre-impregnated material having a third curing temperature,
the first, second and third pre-impregnated materials being selected so that, for a given curing time, the first, second and third curing temperatures are lower than a lamination temperature;
b) laminating the stack (1) at the lamination temperature for a lamination time greater than or equal to the curing time, the support structure (4) and second and third layers (11, 12) not having been laminated before step b).

2. Method according to claim 1, wherein step a) comprises a step a₁) consisting in arranging the first, second and third layers (10, 11, 12) around the stack (1) so as to form a frame for the photovoltaic module and wherein step a) advantageously comprises a step a₂) consisting in arranging shims (6) around the stack (1) so as to demarcate the frame and immobilise the stack (1).

3. Method according to claim 2, wherein the shims (6) arranged in step a₂) each comprise:
- a first part (60) preferably made from metal,
- a second part (61) extending between the first part and the stack (1) and made from a material having a coefficient of thermal expansion comprised between 200 x 10⁻⁶ K⁻¹ and 400 x 10⁻⁶ K⁻¹ at the lamination temperature.

4. Method according to one of claims 1 to 3, wherein step a) comprises a step a₃) consisting in arranging at least one junction box (5) in the support structure (4), step a₃) being executed before step b).

5. Method according to one of claims 1 to 4, wherein the first, second and third pre-impregnated materials each comprise:
- a matrix of a thermosetting polymer or of a thermoplastic polymer, the thermosetting polymer preferably being selected from the group comprising a polyester and a polyepoxide, the thermoplastic polymer preferably being an acrylic polymer;
- fibres of a reinforcement material preferably selected from the group comprising glass, carbon and an aramid;
and wherein the fibres of the first pre-impregnated material are preferentially glass fibres presenting:
- a basis weight value comprised between 100 g/m² and 500 g/m², and
- a percentage by weight comprised between 50% and 70%.

6. Method according to one of claims 1 to 5, wherein the first layer (10) presents a thickness of less than 800 *µ*m after step b).

7. Method according to one of claims 1 to 6, wherein the support structure (4) comprises an alveolar layer (40) advantageously made from a material selected from the group comprising an aramid, aluminium, propylene and polycarbonate and wherein the alveolar layer (40) advantageously presents a thickness comprised between 2 mm and 15 mm, preferably comprised between 8 mm and 12 mm, before step b).

8. Method according to one of claims 1 to 7, wherein the lamination temperature is comprised between 130°C and 170°C and/or the lamination time is at least 15 minutes and/or step b) is executed by applying a lamination pressure comprised between 0.5 x 10⁵ Pa and 5 x 10⁵ Pa to the stack (1).

9. Method according to one of claims 1 to 8, wherein the encapsulation material (3) is made from a thermosetting polymer base, preferably a vinyl ethylene-acetate base, or from a thermoplastic polymer base, preferably selected from the group comprising polyolefin, silicone, polyurethane and polyvinyl butyral.

10. Method according to one of claims 1 to 9, wherein the stack (1) presents a thickness of less than 20 mm, preferably less than 15 mm, after step b).

11. Photovoltaic module comprising a stack (1) successively comprising:
- a first layer (10) transparent in the visible range and made from a first pre-impregnated material,
- a set of photovoltaic cells (2) encapsulated in an encapsulation material (3),
- a second layer (11) made from a second pre-impregnated material,
- a support structure (4) arranged to support the set of photovoltaic cells (2),
- a third layer (12) made from a third pre-impregnated material,
wherein the first, second and third pre-impregnated materials each comprise:
- a polymer matrix of a thermosetting material advantageously selected from the group comprising a polyester and a polyepoxide, or of a thermoplastic polymer chosen from acrylic polymers;
- fibres of a reinforcement material advantageously selected from the group comprising glass, carbon and an aramid.

12. Photovoltaic module according to claim 11, wherein the fibres of the first pre-impregnated material are glass fibres presenting:
- a basis weight value comprised between 100 g/m² and 500 g/m², and
- a percentage by weight comprised between 50% and 70%.

13. Photovoltaic module according to one of claims 11 and 12, wherein the first layer (10) presents a thickness of less than 800 *µ*m.

14. Photovoltaic module according to one of claims 11 to 13, wherein the support structure (4) comprises an alveolar layer (40) and preferentially wherein the alveolar layer (40) is made from a material selected from the group comprising an aramid, aluminium, propylene and polycarbonate.

15. Photovoltaic module according to any one of claims 11 to 14, wherein the stack (1) presents a thickness of less than 20 mm, preferably less than 15 mm.
